# EUROPEAN PATENT SPECIFICATION

(11) **EP 4 586 793 B1**
(45) Date of publication and mention of the grant of the patent: **30.09.2026**
(21) Application number: 25150118.5
(22) Date of filing: 02.01.2025
(51) Int. Cl.: H10N 10/13, H10N 10/17, H10N 10/854, B33Y 80/00, F25B 9/04

(54) **THERMOELECTRIC VORTEX TUBES**
THERMOELEKTRISCHE WIRBELROHRE
TUBES THERMOÉLECTRIQUES À VORTEX

(30) Priority: 09.01.2024 US 202418407762
(43) Date of publication of application: 16.07.2025
(73) Proprietor: Hamilton Sundstrand Corporation, Charlotte, NC 28217-4578 (US)
(72) Inventor: PAL, Debabrata, Hoffman Estates, IL (US); KILCHYK, Viktor, Lancaster, NY (US)
(74) Representative: Dehns

(56) References cited:
- KR-A- 20200 029 708
- US-A1- 2008 029 624
- US-A1- 2019 154 203

## Description

### BACKGROUND

### 1. Field

The present disclosure relates to vortex tubes, and more particularly to thermoelectric aspects of vortex tubes.

### 2. Description of Related Art

Vortex tubes are used to convert potential energy of a compressed gas into two streams, one of hot gas and another of cold gas. The cooled gas can be used for thermal management, e.g. of electronic or mechanical systems. The heated gas can be used for heating if applicable. Vortex tubes are advantageous means for cooling and/or heating. One reason is few or no moving parts. There can be a considerable temperature difference, e.g. up to 160 K, and relatively low pressure ratios can drive the temperature difference, e.g. pressure ratios as low as 1.3.

US 2008/0029624 A1 describes an electric power generator.

The conventional techniques have been considered satisfactory for their intended purpose. However, there is an ever present need for improved systems and methods for utilization of vortex tubes. This disclosure provides a solution for this need.

### SUMMARY

A system is defined in claim 1 and includes a vortex tube. The vortex tube includes an inlet configured to receive compressed gas from a compressed gas source, a spin chamber in fluid communication with the inlet configured to receive a flow of compressed gas from the inlet and to impart spin on the flow of gas, a first outlet in fluid communication with the spin chamber, configured to discharge a cooled portion of the flow of gas, and a second outlet in fluid communication with the spin chamber, configured to discharge a heated portion of the flow of gas. A first thermoelectric terminal is in thermal communication with the first outlet. A second thermoelectric terminal is in thermal communication with the second outlet. An electrical circuit is electrically connected to the first thermoelectric terminal and to the second thermoelectric terminal for electrical conduction of Peltier-effect thermoelectric current. The first thermoelectric terminal includes a first thermoelectric junction of dissimilar metals, and the second thermoelectric terminal includes a second thermoelectric junction of dissimilar metals. The first thermoelectric junction of dissimilar metals includes a first metallic material of the first outlet joined to a second metallic material of the vortex tube.

An expansion nozzle can be defined between the spin chamber and the first outlet for cooling expanded gas. The second outlet can be configured to exhaust reciprocal heated gas from the vortex tube.

The electrical circuit can be configured to harvest energy from the heat flux at the first and second thermoelectric terminals. The electrical circuit can be electrically connected to an electric power consuming system. The electrical circuit can be electrically connected to an electrical energy storage.

The electrical circuit can be configured to supply power to drive heat flux at the first and second thermoelectric terminals. The electrical system can be electrically connected to a source of electrical power.

The first thermoelectric terminal can be in thermal communication with a cold air passage in fluid communication downstream of the first outlet. The second thermoelectric terminal can be in thermal communication with a hot air passage in fluid communication downstream of the second outlet. The first thermoelectric terminal can include a first side of an n-type semiconductor electrically connected to a first leg of the electrical circuit and a first side of a p-type semiconductor electrically connected to a second leg of the electrical circuit. The second thermoelectric junction can include a series connector connecting a second end of the n-type semiconductor in series with a second end of the p-type semiconductor.

The second thermoelectric junction of dissimilar metals can include a third metallic material of the second outlet jointed to the second metallic material of the vortex tube. The first metallic material and the second metallic material can be joined together at an additively manufactured interface, including a single crystal structure boundary devoid of a heat affected zone. The third metallic material and the second metallic material can be joined together at an additively manufactured interface, including a single crystal structure boundary devoid of a heat affected zone. The first, second, and third metallic materials can be a single monolithic structure.

A method is defined in claim 12 and includes driving electrical current through an electrical circuit that is electrically connected to a first thermoelectric terminal and to a second thermoelectric terminal as described above. The first thermoelectric terminal is in thermal communication with a first outlet of the vortex tube, wherein the second thermoelectric terminal is in thermal communication with a second outlet of the vortex tube. The method includes additively manufacturing the vortex tube including an expansion nozzle. Additively manufacturing includes forming a first thermoelectric junction of a first metallic material and a second metallic material in thermal communication with the expansion nozzle.

This can include harvesting energy from the vortex tube. It is also contemplated that driving electrical current can include using electrical power from a power supply to drive heat flux at the first and second thermoelectric terminals to cool down cool gas flow of the first outlet and to heat up hot gas flow of the second outlet and/or to heat up gas flow of the first outlet and cool down gas flow of the second outlet.

Additively manufacturing can include forming a second thermoelectric junction of a third metallic material and the second metallic material in thermal communication with a heated gas outlet of the vortex tube.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic cross-sectional side-elevation view of an embodiment of a system constructed in accordance with the present disclosure, showing two thermoelectric junctions incorporated in a vortex tube; and
Fig. 2 is a schematic view of another embodiment of the system of Fig. 1, showing thermoelectric terminals in thermal communication with the heated and cooled gases from the vortex tube.

### DETAILED DESCRIPTION OF THE PREFERRED EMBODIMENTS

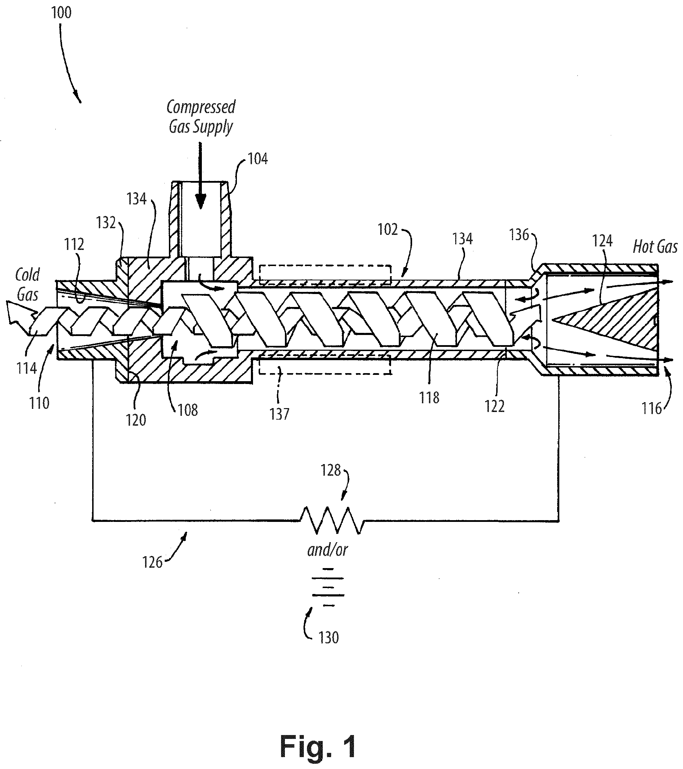

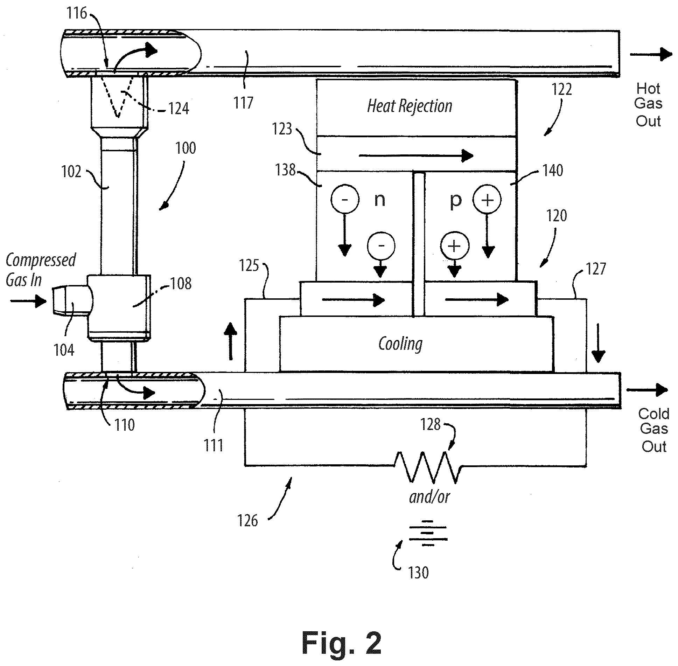

Reference will now be made to the drawings wherein like reference numerals identify similar structural features or aspects of the subject disclosure. For purposes of explanation and illustration, and not limitation, a partial view of an embodiment of a system in accordance with the disclosure is shown in Fig. 1 and is designated generally by reference character 100. Other embodiments of systems in accordance with the disclosure, or aspects thereof, are provided in Fig. 2, as will be described. The systems and methods described herein can be used to enhance temperature difference generated in a vortex tube, and/or to harvest energy from the temperature difference in a vortex tube.

The system 100 includes a vortex tube 102. The vortex tube 102 has an inlet 104 configured to receive compressed gas from a compressed gas source 106, e.g. compressed air. A spin chamber 108 is in fluid communication with the inlet 104 and is configured to receive a flow of compressed gas from the inlet 104 and to impart spin on the flow of gas. A first outlet 110 is in fluid communication with the spin chamber 108, and is configured to discharge a cooled portion of the flow of gas from the spin chamber. An expansion nozzle 112 is defined between the spin chamber 108 and the first outlet 110 for cooling the expanded gas 114, e.g. as in an isenthalpic nozzle or throttle such as used in refrigeration cycles. A second outlet 116 is in fluid communication with an opposite side of the spin chamber 108 from the first outlet 110. The second outlet 110 is configured to discharge a heated portion 118 of the flow of gas. The second outlet 110 is configured to exhaust reciprocal heated gas from the vortex tube, i.e. through a generally cylindrical passage from the spin chamber 108 to the outlet 116 without an expansion nozzle. An optional control valve 124 can be included in the outlet 116.

A first thermoelectric terminal 120 is in thermal communication with the first outlet 110, e.g. through thermal conduction and/or convection. A second thermoelectric terminal 122 is in thermal communication with the second outlet 116, e.g. through thermal conduction and/or convection. An electrical circuit 126 is electrically connected to the first thermoelectric terminal 120 and to the second thermoelectric terminal 122 for electrical conduction of Peltier-effect thermoelectric current.

In an energy harvesting mode, the electrical circuit 126 can be used to harvest energy from the heat flux at the first and second thermoelectric terminals 120, 122 to power a load 128, e.g. any electric power consuming system, and/or can supply energy to an electrical energy storage 130 such as a battery, capacitor, supercapacitor, or the like. In an energy consuming mode, the electrical circuit 126, is configured to supply power from a source of electrical power, e.g. storage 130, a generator, or the like, to drive heat flux at the first and second thermoelectric terminals 120, 120, e.g. to enhance or control gas temperatures of the outlets 110 and/or 116. This can heat the gas flow at the cold outlet 110 and cool gas flow at the hot outlet 116, or can add to the cooling effect at the cold outlet 110 and add heat to the gas flow at the hot outlet 116, depending on which direction the current is driven in the circuit 126.

The first thermoelectric terminal 120 can include a first thermoelectric junction of dissimilar metals 132, 134, and the second thermoelectric terminal 122 can include a second thermoelectric junction of dissimilar metals 134, 136. The first thermoelectric junction of dissimilar metals includes a first metallic material 132 of the first outlet 110 joined to a second metallic material 134 of the vortex tube 102. The second thermoelectric junction of dissimilar metals includes a third metallic material 136 of the second outlet 116 jointed to the second metallic material 134 of the vortex tube 102. The first metallic material 132 and the second metallic material 134 are joined together at an additively manufactured interface (the terminal 120), including a single crystal structure boundary, i.e. no braze or solder are in the interface, and the interface is devoid of a heat affected zone such as would result from welding. The third metallic material 136 and the second metallic material 134 are joined together at an additively manufactured interface, i.e. the terminal 122, including a similar single crystal structure boundary from additive manufacturing as that described above for terminal 120. The first, second, and third metallic materials 132, 134, 136 are a single monolithic additively manufactured structure, although those skilled in the art will readily appreciate that conventional manufacturing techniques can be used to form this structure as well. It is also contemplated that a buffer element 137 can be included in the vortex tube 102, separating the hot and cold gas regions. This can reduce or eliminate parasitic heat transfer within the vortex tube 102 itself. The layer of buffer element 137 can be made with a metal additively manufactured foam, lattice, voided structure, or the like, to work as thermal insulation. It could also be made from a polymer as an insert.

With reference now to Fig. 2, the system 100 is shown with a different thermoelectric terminal configuration. The first thermoelectric terminal 120 is in thermal communication with a cold air passage 111 in fluid communication downstream of the first outlet 110. The second thermoelectric terminal 122 is in thermal communication with a hot air passage 117 in fluid communication downstream of the second outlet 116. The first thermoelectric terminal 120 includes a first side of an n-type semiconductor 138 electrically connected to a first leg 125 of the electrical circuit 126 and a first side of a p-type 140 semiconductor electrically connected to a second leg 127 of the electrical circuit 126. The first sides of the n-type and p-type semiconductors 138, 140 are not directly connected together, i.e. they are isolated from one another. The first and second legs 125, 127 of the circuit 126 are on opposite sides of the load/storage 128/130. The second thermoelectric junction 122 includes a series connector 123 connecting a second end of the n-type semiconductor 138 in series with a second end of the p-type semiconductor 140. The configuration in Fig. 2 can run in the energy harvesting or energy consuming modes described above with respect to Fig. 1. Those skilled in the art will readily appreciate that dissimilar metal junctions can be used in the configuration in Fig. 2 in addition to the semiconductor based terminals, or any other suitable Peltier-Seebeck elements.

The method includes driving electrical current through an electrical circuit that is electrically connected to a first thermoelectric terminal 120 and to a second thermoelectric terminal 122 as described above. Driving electrical current can include harvesting energy from the vortex tube 102. It is also contemplated that driving electrical current can include using electrical power from a power supply 130 to drive heat flux at the first and second thermoelectric terminals 120, 122 to cool down cool gas flow of the first outlet 110 and/or to heat up hot gas flow of the second outlet 116.

Systems and methods as disclosed herein provide potential benefits including the following. They can provide higher cooling capacity per unit weight as compared to either (thermoelectric generator) TEG or (vortex tube) VT standalone devices. They can also operate with no moving parts, and with relative simplicity, small size and low costs, high reliability, and increasing cooling output with no or minimal weight change relative to traditional systems. Systems and methods as disclosed herein can be applicable to a hot spot/electronic cooling or any suitable application.

The methods and systems of the present disclosure, as described above and shown in the drawings, provide for enhancing temperature difference generated in a vortex tube by supplying electrical power, and/or to harvest energy from the temperature difference in a vortex tube.

## Claims

1. A system comprising:
a vortex tube (102) including:
an inlet (104) configured to receive compressed gas from a compressed gas source;
a spin chamber (108) in fluid communication with the inlet (104) configured to receive a flow of compressed gas from the inlet (104) and to impart spin on the flow of gas;
a first outlet (110) in fluid communication with the spin chamber (108) configured to discharge a cooled portion of the flow of gas; and
a second outlet (116) in fluid communication with the spin chamber (108) configured to discharge a heated portion of the flow of gas;
a first thermoelectric terminal (120) in thermal communication with the first outlet;
a second thermoelectric terminal (122) in thermal communication with the second outlet; and
an electrical circuit (126) electrically connected to the first thermoelectric terminal and to the second thermoelectric terminal for electrical conduction of Peltier-effect thermoelectric current, the first thermoelectric terminal (120) includes a first thermoelectric junction of dissimilar metals (132, 134), wherein the second thermoelectric terminal (122) includes a second thermoelectric junction of dissimilar metals (134, 136),
and wherein the first thermoelectric junction of dissimilar metals includes a first metallic material (132) of the first outlet (110) joined to a second metallic material (134) of the vortex tube (102).

2. The system as recited in claim 1, wherein the electrical circuit is configured to harvest energy from heat flux at the first and second thermoelectric terminals.

3. The system as recited in claim 2, wherein the electrical circuit is electrically connected to an electric power consuming system, or electrical energy storage.

4. The system as recited in any preceding claim, wherein the electrical circuit is configured to supply power to drive heat flux at the first and second thermoelectric terminals.

5. The system as recited in claim 4, wherein the electrical circuit is electrically connected to a source of electrical power.

6. The system as recited in any preceding claim, wherein the first thermoelectric terminal (120) is in thermal communication with a cold air passage in fluid communication downstream of the first outlet, and wherein the second thermoelectric terminal is in thermal communication with a hot air passage in fluid communication downstream of the second outlet.

7. The system as recited in claim 6, wherein the first thermoelectric terminal includes a first side of an n-type semiconductor (138) electrically connected to a first leg (125) of the electrical circuit and a first side of a p-type semiconductor (140) electrically connected to a second leg (127) of the electrical circuit, and wherein the second thermoelectric terminal (122) includes a series connector connecting a second end of the n-type semiconductor in series with a second end of the p-type semiconductor.

8. The system as recited in any preceding claim, wherein the second thermoelectric junction of dissimilar metals includes a third metallic material (136) of the second outlet joined to the second metallic material of the vortex tube (102).

9. The system as recited in claim 8, wherein the first metallic material and the second metallic material are joined together at an additively manufactured interface, including a single crystal structure boundary devoid of a heat affected zone such as would result from welding.

10. The system as recited in claim 9, wherein the third metallic material and the second metallic material are joined together at an additively manufactured interface, including a single crystal structure boundary devoid of a heat affected zone such as would result from welding.

11. The system as recited in claim 10, wherein the first, second, and third metallic materials are a single monolithic structure.

12. The system as recited in any preceding claim, wherein an expansion nozzle is defined between the spin chamber (108) and the first outlet for cooling expanded gas, and wherein the second outlet is configured to exhaust reciprocal heated gas from the vortex tube (102).

13. A method comprising:
additively manufacturing a vortex tube (102) including an expansion nozzle, wherein additively manufacturing the vortex tube includes forming a first thermoelectric junction of a first thermoelectric terminal using a first metallic material and a second metallic material in thermal communication with the expansion nozzle; and
providing an electrical circuit (126) configured to drive electrical current through the first thermoelectric terminal and to a second thermoelectric terminal, wherein the first thermoelectric terminal is in thermal communication with a first outlet (110) of the vortex tube (102), and wherein the second thermoelectric terminal is in thermal communication with a second outlet (116) of the vortex tube (102).

14. The method as recited in claim 13, wherein the electrical circuit is configured to harvest energy from the vortex tube (102), and optionally wherein the electrical circuit is configured to use electrical power from a power supply to drive heat flux at the first and second thermoelectric terminals to cool down cool gas flow of the first outlet (110) and/or to heat up hot gas flow of the second outlet (116).

15. The method as recited in claim 14, wherein additively manufacturing the vortex tube includes forming a second thermoelectric junction of a third metallic material and the second metallic material in thermal communication with the second outlet of the vortex tube (102).

## Patentansprüche

1. System, umfassend:
ein Wirbelrohr (102), beinhaltend:
einen Einlass (104), der ausgelegt ist, um Druckgas aus einer Druckgasquelle aufzunehmen;
eine Drehkammer (108) in Fluidverbindung mit dem Einlass (104), die dazu ausgelegt ist, einen Strom von Druckgas von dem Einlass (104) aufzunehmen und den Strom von Gas in Drehung zu versetzen;
einen ersten Auslass (110) in Fluidverbindung mit der Drehkammer (108), der dazu ausgelegt ist, einen gekühlten Teil des Stroms von Gas abzuführen; und
einen zweiten Auslass (116) in Fluidverbindung mit der Drehkammer (108), der dazu ausgelegt ist, einen erwärmten Teil des Stroms von Gas abzuführen;
einen ersten thermoelektrischen Anschluss (120) in thermischer Verbindung mit dem ersten Auslass;
einen zweiten thermoelektrischen Anschluss (122) in thermischer Verbindung mit dem zweiten Auslass; und
einen elektrischen Schaltkreis (126), der elektrisch mit dem ersten thermoelektrischen Anschluss und dem zweiten thermoelektrischen Anschluss zur elektrischen Leitung eines thermoelektrischen Stroms nach dem Peltier-Effekt verbunden ist, wobei der erste thermoelektrische Anschluss (120) einen ersten thermoelektrischen Übergang aus unterschiedlichen Metallen (132, 134) beinhaltet, wobei der zweite thermoelektrische Anschluss (122) einen zweiten thermoelektrischen Übergang aus unterschiedlichen Metallen (134, 136) beinhaltet und wobei der erste thermoelektrische Übergang aus unterschiedlichen Metallen ein erstes metallisches Material (132) des ersten Auslasses (110) beinhaltet, das an ein zweites metallisches Material (134) des Wirbelrohrs (102) verbunden ist.

2. System nach Anspruch 1, wobei der elektrische Schaltkreis dazu ausgelegt ist, Energie aus einem Wärmefluss an dem ersten und dem zweiten thermoelektrischen Anschluss zu gewinnen.

3. System nach Anspruch 2, wobei der elektrische Schaltkreis elektrisch mit einem Stromverbrauchssystem oder einem elektrischen Energiespeicher verbunden ist.

4. System nach einem der vorhergehenden Ansprüche, wobei der elektrische Schaltkreis dazu ausgelegt ist, Leistung zu liefern, um einen Wärmefluss an dem ersten und dem zweiten thermoelektrischen Anschluss anzutreiben.

5. System nach Anspruch 4, wobei der elektrische Schaltkreis elektrisch mit einer Quelle elektrischer Leistung verbunden ist.

6. System nach einem der vorhergehenden Ansprüche, wobei der erste thermoelektrische Anschluss (120) in thermischer Verbindung mit einem Kaltluftkanal in Fluidverbindung stromabwärts des ersten Auslasses steht und wobei der zweite thermoelektrische Anschluss in thermischer Verbindung mit einem Heißluftkanal in Fluidverbindung stromabwärts des zweiten Auslasses steht.

7. System nach Anspruch 6, wobei der erste thermoelektrische Anschluss eine erste Seite eines n-Typ-Halbleiters (138), die elektrisch mit einem ersten Zweig (125) des elektrischen Schaltkreises verbunden ist, und eine erste Seite eines p-Typ-Halbleiters (140), die elektrisch mit einem zweiten Zweig (127) des elektrischen Schaltkreises verbunden ist, beinhaltet, und wobei der zweite thermoelektrische Anschluss (122) einen Reihenverbinder beinhaltet, der ein zweites Ende des n-Typ-Halbleiters in Reihe mit einem zweiten Ende des p-Typ-Halbleiters verbindet.

8. System nach einem vorhergehenden Anspruch, wobei der zweite thermoelektrische Übergang aus unterschiedlichen Metallen ein drittes metallisches Material (136) des zweiten Auslasses beinhaltet, das mit dem zweiten metallischen Material des Wirbelrohrs (102) verbunden ist.

9. System nach Anspruch 8, wobei das erste metallische Material und das zweite metallische Material an einer additiv gefertigten Grenzfläche aneinander verbunden sind, die eine Einkristallstrukturgrenze beinhaltet, die frei von einer Wärmeeinflusszone ist, wie sie beim Schweißen entstehen würde.

10. System nach Anspruch 9, wobei das dritte metallische Material und das zweite metallische Material an einer additiv gefertigten Grenzfläche aneinander verbunden sind, die eine Einkristallstrukturgrenze beinhaltet, die frei von einer Wärmeeinflusszone ist, wie sie beim Schweißen entstehen würde.

11. System nach Anspruch 10, wobei das erste, zweite und dritte metallische Material eine einzige monolithische Struktur sind.

12. System nach einem der vorhergehenden Ansprüche, wobei zwischen der Drehkammer (108) und dem ersten Auslass eine Expansionsdüse zum Kühlen von expandiertem Gas definiert ist und wobei der zweite Auslass dazu ausgelegt ist, wechselseitig erwärmtes Gas aus dem Wirbelrohr (102) abzuführen.

13. Verfahren, umfassend:
additives Fertigen eines Wirbelrohrs (102), das eine Expansionsdüse beinhaltet, wobei das additive Fertigen des Wirbelrohrs ein Bilden eines ersten thermoelektrischen Übergangs eines ersten thermoelektrischen Anschlusses unter Verwendung eines ersten metallischen Materials und eines zweiten metallischen Materials in thermischer Verbindung mit der Expansionsdüse beinhaltet; und
Bereitstellen eines elektrischen Schaltkreises (126), der dazu ausgelegt ist, elektrischen Strom durch den ersten thermoelektrischen Anschluss und zu einem zweiten thermoelektrischen Anschluss anzutreiben, wobei der erste thermoelektrische Anschluss in thermischer Verbindung mit einem ersten Auslass (110) des Wirbelrohrs (102) steht und wobei der zweite thermoelektrische Anschluss in thermischer Verbindung mit einem zweiten Auslass (116) des Wirbelrohrs (102) steht.

14. Verfahren nach Anspruch 13, wobei der elektrische Schaltkreis dazu ausgelegt ist, Energie aus dem Wirbelrohr (102) zu gewinnen, und wobei der elektrische Schaltkreis optional dazu ausgelegt ist, elektrische Leistung aus einer Leistungsversorgung zu nutzen, um einen Wärmefluss an dem ersten und dem zweiten thermoelektrischen Anschluss anzutreiben, um einen Kaltgasstrom des ersten Auslasses (110) abzukühlen und/oder einen Heißgasstrom des zweiten Auslasses (116) zu erwärmen.

15. Verfahren nach Anspruch 14, wobei das additive Fertigen des Wirbelrohrs ein Bilden eines zweiten thermoelektrischen Übergangs aus einem dritten metallischen Material und dem zweiten metallischen Material in thermischer Verbindung mit dem zweiten Auslass des Wirbelrohrs (102) beinhaltet.

## Revendications

1. Système comprenant :
un tube à vortex (102) comportant :
une entrée (104) configurée pour recevoir du gaz comprimé à partir d'une source de gaz comprimé ;
une chambre de rotation (108) en communication fluidique avec l'entrée (104) configurée pour recevoir un flux de gaz comprimé à partir de l'entrée (104) et pour imprimer une rotation au flux de gaz ;
une première sortie (110) en communication fluidique avec la chambre de rotation (108) configurée pour décharger une partie refroidie du flux de gaz ; et
une seconde sortie (116) en communication fluidique avec la chambre de rotation (108) configurée pour décharger une partie chauffée du flux de gaz ;
une première borne thermoélectrique (120) en communication thermique avec la première sortie ;
une seconde borne thermoélectrique (122) en communication thermique avec la seconde sortie ; et
un circuit électrique (126) connecté électriquement à la première borne thermoélectrique et à la seconde borne thermoélectrique pour la conduction électrique du courant thermoélectrique à effet Peltier, la première borne thermoélectrique (120) comporte une première jonction thermoélectrique de métaux dissemblables (132, 134), dans lequel la seconde borne thermoélectrique (122) comporte une seconde jonction thermoélectrique de métaux dissemblables (134, 136), et dans lequel la première jonction thermoélectrique de métaux dissemblables comporte un premier matériau métallique (132) de la première sortie (110) relié à un deuxième matériau métallique (134) du tube à vortex (102).

2. Système selon la revendication 1, dans lequel le circuit électrique est configuré pour récupérer l'énergie du flux thermique aux première et seconde bornes thermoélectriques.

3. Système selon la revendication 2, dans lequel le circuit électrique est connecté électriquement à un système de consommation d'énergie électrique ou à un système de stockage d'énergie électrique.

4. Système selon une quelconque revendication précédente, dans lequel le circuit électrique est configuré pour fournir une puissance permettant de générer un flux de chaleur aux première et seconde bornes thermoélectriques.

5. Système selon la revendication 4, dans lequel le circuit électrique est connecté électriquement à une source d'énergie électrique.

6. Système selon une quelconque revendication précédente, dans lequel la première borne thermoélectrique (120) est en communication thermique avec un passage d'air froid en communication fluidique en aval de la première sortie, et dans lequel la seconde borne thermoélectrique est en communication thermique avec un passage d'air chaud en communication fluidique en aval de la seconde sortie.

7. Système selon la revendication 6, dans lequel la première borne thermoélectrique comporte une première face d'un semi-conducteur de type n (138) connectée électriquement à une première branche (125) du circuit électrique et une première face d'un semi-conducteur de type p (140) connectée électriquement à une seconde branche (127) du circuit électrique, et dans lequel la seconde borne thermoélectrique (122) comporte un connecteur série connectant une seconde extrémité du semi-conducteur de type n en série avec une seconde extrémité du semi-conducteur de type p.

8. Système selon une quelconque revendication précédente, dans lequel la seconde jonction thermoélectrique de métaux dissemblables comporte un troisième matériau métallique (136) de la seconde sortie relié au deuxième matériau métallique du tube à vortex (102).

9. Système selon la revendication 8, dans lequel le premier matériau métallique et le deuxième matériau métallique sont reliés ensemble au niveau d'une interface fabriquée par fabrication additive, comportant une limite de structure monocristalline dépourvue de zone affectée thermiquement telle que celle qui résulterait du soudage.

10. Système selon la revendication 9, dans lequel le troisième matériau métallique et le deuxième matériau métallique sont reliés ensemble au niveau d'une interface fabriquée par fabrication additive, comportant une limite de structure monocristalline dépourvue de zone affectée thermiquement telle que celle qui résulterait du soudage.

11. Système selon la revendication 10, dans lequel les premier, deuxième et troisième matériaux métalliques forment une structure monolithique unique.

12. Système selon une quelconque revendication précédente, dans lequel une buse d'expansion est définie entre la chambre de rotation (108) et la première sortie pour refroidir le gaz dilaté, et dans lequel la seconde sortie est configurée pour évacuer le gaz chauffé réciproquement à partir du tube à vortex (102).

13. Procédé comprenant :
la fabrication additive d'un tube à vortex (102) comportant une buse d'expansion, dans lequel la fabrication additive du tube à vortex comporte la formation d'une première jonction thermoélectrique d'une première borne thermoélectrique à l'aide d'un premier matériau métallique et d'un second matériau métallique en communication thermique avec la buse d'expansion ; et
la fourniture d'un circuit électrique (126) configuré pour faire circuler un courant électrique à travers la première borne thermoélectrique et vers une seconde borne thermoélectrique, dans lequel la première borne thermoélectrique est en communication thermique avec une première sortie (110) du tube à vortex (102), et dans lequel la seconde borne thermoélectrique est en communication thermique avec une seconde sortie (116) du tube à vortex (102).

14. Procédé selon la revendication 13, dans lequel le circuit électrique est configuré pour récupérer l'énergie à partir du tube à vortex (102), et éventuellement dans lequel le circuit électrique est configuré pour utiliser l'énergie électrique à partir d'une alimentation pour générer un flux de chaleur aux première et seconde bornes thermoélectriques afin de refroidir le flux de gaz froid de la première sortie (110) et/ou de chauffer le flux de gaz chaud de la seconde sortie (116).

15. Procédé selon la revendication 14, dans lequel la fabrication additive du tube à vortex comporte la formation d'une seconde jonction thermoélectrique d'un troisième matériau métallique et du deuxième matériau métallique en communication thermique avec la seconde sortie du tube à vortex (102).
